# FASCICULE DE BREVET EUROPEEN

(11) **EP 0 578 526 B1**
(45) Date de publication et mention de la délivrance du brevet: **15.10.1997**
(21) Numéro de dépôt: 93401608.0
(22) Date de dépôt: 23.06.1993
(51) Int. Cl.: H03K 3/356

(54) **Circuit de commutation de haute tension**
Hochspannungsschaltkreis
High-voltage switch circuit

(30) Priorité: 06.07.1992 FR 9208332
(43) Date de publication de la demande: 12.01.1994
(73) Titulaire: SGS-THOMSON MICROELECTRONICS S.A., 94250 Gentilly (FR)
(72) Inventeur: Yero, Emilio, F-75116 Paris (FR); Rouy, Olivier, F-75116 Paris (FR)
(74) Mandataire: Schmit, Christian Norbert Marie

(56) Documents cités:
- US-A- 4 920 284
- IBM TECHNICAL DISCLOSURE BULLETIN. vol. 32, no. 7, Décembre 1989, NEW YORK US pages 454 - 455 '5-VOLT SIGNAL LEVEL SHIFTER IN A 3-VOLT CMOS CIRCUIT'
- IBM TECHNICAL DISCLOSURE BULLETIN. vol. 25, no. 7A, Décembre 1982, NEW YORK US page 3505 CONCANNON 'FET CURRENT DRIVER HAVING LARGE DYNAMIC RANGE'
- PATENT ABSTRACTS OF JAPAN vol. 11, no. 170 (P-581)2 Juin 1987

## Description

L'invention concerne un circuit de commutation d'une haute tension applicable notamment dans les circuits intégrés programmables.

Dans un circuit intégré, il est souvent nécessaire de disposer de niveaux de tension plus élevés que les niveaux logiques nominaux du circuit. Par exemple, dans un circuit mémoire, les signaux sont en logique 5 volts mais pour la programmation, il est nécessaire de disposer d'un niveau de haute tension VPP de l'ordre de 12 volts. Il faut donc une circuiterie qui, sur un signal de commande en logique 5 volts, va translater ce signal de commande en logique 12 volts, et le commuter en sortie sur un circuit de charge.

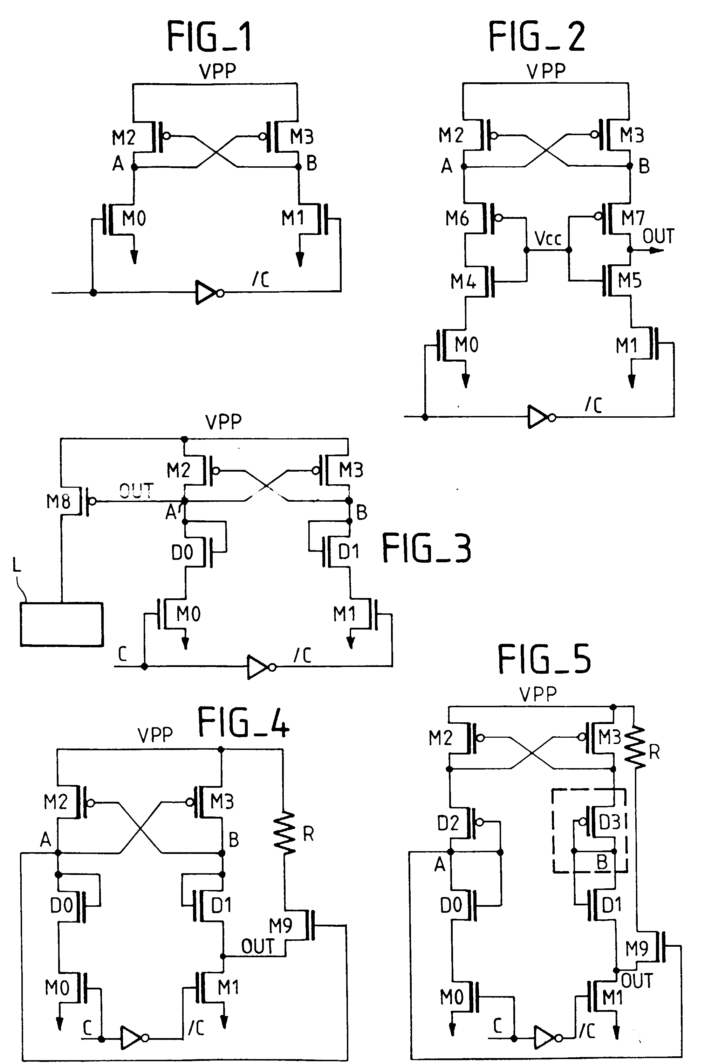

Une telle circuiterie est représentée sur la figure 1. Elle comporte classiquement deux branches. Chaque branche comprend un transistor de type N de commutation, M0, respectivement M1 et un transistor de type P de charge commandée, M2, respectivement M3 montés en série entre la masse et la haute tension VPP. Le transistor N d'une branche est commandé sur sa grille par un signal de commutation C, le transistor N de l'autre branche est commandé sur sa grille par le signal de commutation inversé /C. Le transistor P de chaque branche a sa grille commandée par le point de connexion entre le transistor P et le transistor N de l'autre branche.

De cette manière, en prenant comme sortie l'un des points de connexion entre le transistor P et le transistor N de l'une des branches, on obtient en sortie un niveau zéro volt ou le niveau VPP, par exemple 12 volts. Le fonctionnement d'un tel circuit est en effet le suivant : lorsque le signal de commutation C est à 5 volts, le transistor M0 de type N, dont le potentiel de grille est alors égal à 5 volts et qui a sa source reliée à la masse, est passant. Le transistor M1 de type N, dont le potentiel de grille, fixé par le signal de commutation inversé /C, est alors égal à 0 volt, est bloqué. Le transistor M0 amène donc le potentiel de son drain vers 0 volt. Le transistor de type P M3 qui est commandé sur sa grille par le drain du transistor M0 et qui a sa source reliée à la haute tension VPP est passant. Le transistor M1 étant bloqué, le point de connexion B entre les transistors M3 et M1 tend vers 12 volts. Le transistor de type P M2 qui reçoit donc sur sa grille une tension proche de 12 volts, est bloqué. Un équilibre s'établit alors. Les transistors M1 et M2 étant bloqués, le potentiel du drain du transistor M0 se stabilise à 0 volt et le potentiel du drain du transistor M3 se stabilise à VPP.

Lorsque le signal de commutation C passe à 0 volt, les rôles sont inversés. A l'équilibre, le point de connexion A entre les transistors M0 et M2 sera à 12 volts et le point de connexion B entre les transistors M1 et M3 sera à 0 volt.

Avec un tel circuit, les chutes de tension grille-drain, grille-source ou drain-source sont trop importantes. Elles sont égales à la haute tension VPP. Les transistors subissent un stress qui peut provoquer la dégradation de leur oxyde de grille par un phénomène de vieillissement, le perçage du canal entre drain et source ou le claquage des jonctions drain-substrat ou caisson, source-substrat ou caisson. Ces phénomènes sont bien connus.

Le stress des transistors étant un inconvénient majeur, une protection classique utilisée est un montage cascode de protection des transistors P de charge et un autre montage cascode de protection des transistors N de commutation, comme représenté sur la figure 2. Dans chaque branche un transistor P de protection M6, M7 et un transistor N de protection M4, M5, sont montés en série, entre le transistor P M2, M3 et le transistor N M0, M1 du circuit de commutation. Leurs grilles sont reliées à la tension d'alimentation nominale Vcc du circuit : les transistors N de protection M4, M5 sont ainsi montés en cascode pour protéger les transistors N de commutation M0, M1 et les transistors P de protection sont montés en cascode pour protéger les transistors P de charge M2, M3. Ces derniers sont chacun commandés sur leur grille par le point de connexion entre le transistor P de commutation et le transistor P de protection de l'autre branche. Le niveau de sortie OUT est pris entre le transistor P et le transistor N de protection de l'une des branches, dans l'exemple de la figure 2, entre les transistors M5 et M7.

Les transistors N de protection M4, M5 qui ont leurs grilles à Vcc et une tension de seuil Vtn - typiquement 1 volt - empêchent leurs sources de monter au-dessus du niveau Vcc-Vtn, sinon ils ne seraient plus passants.

Le potentiel du drain des transistors N de commutation M0, M1 ne peut donc pas monter plus haut que Vcc-Vtn soit typiquement 4 volts.

Les transistors P de protection M6, M7 qui ont leurs grilles à Vcc et une tension de seuil en valeur absolue Vtp - typiquement 1 volt - empêchent leurs sources de descendre en-dessous de Vcc-Vtp, sinon ils ne seraient plus passants.

Le potentiel du drain des transistors P de charge M2, M3 ne peut donc pas descendre plus bas que Vcc+Vtp, soit typiquement 6 volts. Comme le potentiel de drain d'une branche est appliqué sur la grille du transistor P de charge de l'autre branche, il en est de même pour ces grilles.

Ainsi, on commute sur la sortie OUT soit 0 volt, soit VPP, selon le niveau du signal de commutation C, mais la chute de tension grille-drain, grille-source ou source-drain, des différents transistors de protection de charge et de commutation est bien inférieure à celle du montage précédent (figure 1), puisque les chutes de tension sont réparties entre quatre transistors alors qu'elles ne l'étaient que sur deux au départ. Dans un tel montage, les 2 transistors P d'une branche servent à commuter le VPP tandis que les 2 transistors N d'une branche servent à commuter le 0 volt.

Or il est possible que la tension d'alimentation Vcc ne soit pas appliquée pendant un certain laps de temps. Dans ces conditions, si la haute tension VPP est présente, on retrouve des chutes de tension importantes aux bornes des transistors de protection des montages cascode.

En effet, si Vcc=0, les transistors de protection de type P ont 0 volt sur leurs grilles et peuvent avoir VPP sur leurs sources. Ils sont alors conducteurs et transmettent VPP sur leurs drains : les transistors de protection de type N ont alors VPP sur leurs drains alors que leurs grilles sont à 0 volt.
Les transistors de protection de type P et N peuvent donc être soumis à un stress important.

Dans l'invention, on propose de résoudre ce problème en proposant un autre type de montage. Dans le montage précédent de la figure 2, la distribution des chutes de tension permettait à l'équilibre de ramener à 6 volts ou moins les chutes de tension entre grille et drain, grille et source ou drain et source, pour des niveaux normaux des tensions VPP et Vcc.

En forçant une petite chute de tension en plus ou en moins sur les drains des transistors P et des transistors N de chacune des branches, on diminue la chute de tension entre grille et drain, grille et source et drain et source. Une diminution de 1 volt réduit le champ électrique suffisamment pour abaisser le stress de plusieurs ordres de grandeur.

Si on place une diode polarisée en direct, en série, entre le transistor P et le transistor N de commutation de chacune des branches, elle impose une chute de tension égale à sa tension de seuil. Ainsi, on ajoute une chute de tension dans chaque branche. Par exemple au drain du transistor P de l'une des branches, on aura un potentiel égal à la tension de seuil dè la diode et non plus à 0 volt. Au drain du transistor N, on aura un potentiel VPP diminué de la tension de seuil de la diode. Le dispositif de protection ne permet pas de commuter sur une même sortie, 0 volt ou VPP. La chute de tension due à la diode, se répercute sur l'un des niveaux de tension commuté.

Dans un mode de réalisation de l'invention, la sortie OUT du circuit est appliquée à la borne d'une résistance, l'autre borne étant reliée à la haute tension et on cherche à commuter sur la sortie les niveaux 0 volt et VPP très précisément.

Dans l'invention on propose alors d'intercaler entre la résistance et la sortie OUT un transistor d'isolation commandé sur sa grille par une sortie prise sur l'autre branche du circuit de commutation.

La sortie prise sur l'autre branche entre le transistor P et la diode va permettre de rendre passant ou non le transistor d'isolation et d'appliquer sur la borne de la résistance 0 volt ou VPP.

Dans un perfectionnement, on place une diode entre le point de sortie qui commande la grille du transistor d'isolation et le transistor P : la sortie qui commande la grille se retrouve alors entre deux diodes. La première diode augmente le niveau 0 volt d'une tension de seuil et la deuxième diode diminue le niveau VPP d'une tension de seuil.

Telle qu'elle est revendiquée, l'invention concerne donc un circuit de commutation d'une haute tension VPP. Ce circuit comprend deux branches ayant chacune un transistor P et un transistor N en série entre la haute tension VPP et la masse. Le transistor P est commandé sur sa grille par le point de connexion entre le transistor P et le transistor N de l'autre branche. Le transistor N d'une branche est commandé sur sa grille par un signal de commutation et le transistor de l'autre branche est commandé sur sa grille par le signal de commutation inversé.

Selon l'invention, une diode est connectée entre le transistor P et le transistor N dans chacune des branches et un transistor d'isolation est placé entre une résistance et une sortie du circuit fournie par une branche, ce transistor de sélection étant commandé sur sa grille par une sortie prise sur l'autre branche.

Avantageusement, une diode est placée sur cette autre branche entre la première diode et le transistor P. De cette manière le transistor de sélection associé à la résistance est lui-même protégé du stress.

D'autres caractéristiques et avantages de l'invention sont détaillés dans la description qui suit, faite à titre indicatif et non limitatif de l'invention et en référence aux dessins annexés dans lesquels :
- la figure 1 représente un circuit de commutation sans protection déjà décrite,
- la figure 2 représente un circuit de commutation avec un dispositif de protection selon l'art antérieur déjà décrite,
- la figure 3 représente un circuit de commutation de haute tension utilisé dans l'invention,
- la figure 4 représente un mode de réalisation d'un circuit de commutation de haute tension sur une charge résistive selon l'invention,
- la figure 5 représente un perfectionnement du circuit de commutation représenté sur la figure 4.

Les figures 1 et 2 ont déjà été décrites. On choisit d'utiliser les mêmes références pour les éléments communs aux figures 1, 2, 3, 4 et 5.

Le circuit de commutation représenté sur la figure 3, comporte deux branches. Chaque branche comprend un transistor de type P, M2, respectivement M3 en série avec une diode en direct D0, respectivement D1 et un transistor de type N M0, respectivement M1. Ces deux transistors et la diode sont placés en série dans chaque branche entre la haute tension VPP et la masse. La source du transistor M2, respectivement M3, est reliée à la haute tension VPP. Le drain du transistor M2, respectivement M3, est relié à l'anode de la diode D0, respectivement D1. Le drain du transistor M0, respectivement M1, est relié à la cathode de la diode D0, respectivement D1. La source du transistor M0, respectivement M1, est reliée à la masse.

Dans la première branche, le transistor M2 de type P a sa grille commandée par le point de connexion B entre le transistor M3 et la diode D1 de la deuxième branche. Le transistor M0 de type N a sa grille commandée par le signal de commutation C. Dans la deuxième branche, le transistor M3 de type P a sa grille commandée par le point de connexion A entre le transistor M2 et la diode D0 de la première branche et le transistor M1 de type N a sa grille commandée par le signal de commutation inversé /C.

Les diodes D0, D1 étant polarisées en direct, elles imposent une chute de tension à leurs bornes de l'ordre de leur tension de seuil: vO pour la diode D0, v1 pour la diode D1.

Lorsque le signal de commutation C est à 5 volts, le transistor M0 est passant et le transistor M1 est bloqué. A l'équilibre, le transistor M0 amène le potentiel de son drain à 0 volt, mais la diode D0 impose une chute de tension égale à sa tension de seuil v0 à ses bornes. Au point de connexion A entre la diode D0 et le transistor M2, la tension est alors égale à cette tension de seuil v0. Dans la deuxième branche, le même phénomène se produit: la diode D1 impose une chute de tension à ses bornes égale à sa tension de seuil v1. Ainsi, au point de connexion B entre la diode D1 et le transistor M3, la tension est égale à VPP à l'équilibre puisque le transistor M3 est passant. Le potentiel du drain du transistor M1 est lui égal à la tension VPP moins la tension de seuil v1 de la diode D1. On déduit aisément par symétrie le fonctionnement du circuit, lorsque le signal de commutation est à 0 volt.

Dans ce premier mode de réalisation du circuit de commutation, la chute de tension grille-drain, grille-source ou drain-source des transistors est au maximum de VPP-vi, où vi est la tension de seuil d'une diode. On a réduit la chute de tension de la valeur d'une tension de seuil de diode, ce qui permet, d'empêcher le stress des transistors du circuit de commutation et la dégradation de leur oxyde de grille. Les diodes ne sont pas stressées non plus.

Dans un exemple, avec VPP=12 volts, v0=v1=1 volt, quand le signal de commutation est à 5 volts, le transistor M0 a sa source à la masse, son drain à 0 volt, sa grille à 5 volts ; le transistor M1 a sa source à la masse, son drain à VPP-v1=11 volts, sa grille à 0 volt ; le transistor M2 a sa source à v0=1 volt, son drain à 12 volts et sa grille à VPP-v1=11 volts ; le transistor M3 a sa source à 12 volts, son drain à 12 volts et sa grille à v0=1 volt. La chute de tension maximum entre les différentes électrodes est donc égale à 11 volts, ce qui permet d'empêcher le stress de ces transistors.

Dans un exemple représenté sur la figure 2, les diodes sont réalisées par des transistors de type N ou P, dont la grille est reliée au drain. Par exemple, la diode D0 de la première branche est un transistor de type N ayant sa grille reliée à son drain. Son drain est connecté au drain du transistor M2 et sa source est connectée au drain du transistor M0. La tension de seuil de diodes est alors augmentée par l'effet substrat : la tension de seuil augmente avec la polarisation de la source du transistor. Ainsi, on bénéficie avantageusement de cet effet substrat pour réduire encore les chutes de tension sur les transistors de commutation et de charge.

Si on prend le signal de sortie OUT du circuit de commutation que l'on vient de décrire, au point de connexion entre la diode D1 et le transistor de type P M3, la sortie OUT prendra comme valeur soit VPP soit la tension de seuil v1 de la diode D1.

Si on prend la sortie OUT au point de connexion entre le transistor de type N M1 et la diode D1, le niveau de sortie vaudra soit 0 volt, soit VPP-v1.

Le circuit décrit ne permet pas de commuter VPP et 0 volt sur la même sortie. Selon la sortie choisie, les niveaux de sortie seront VPP-vi et 0 volt, ou VPP et vi, vi étant la tension de seuil d'une diode Di (D0 ou D1 selon que l'on prend la sortie sur la première ou la deuxième branche).

Dans le cas de la commande d'un transistor de transfert pour commuter un haut niveau de tension VPP sur une charge, il est en fait seulement nécessaire, de disposer d'un seul plein niveau de tension: VPP pour bloquer un transistor de transfert de type P ou zéro volt pour bloquer un transistor de transfert de type N. Supposons en effet, comme représenté sur la figure 3, que la sortie du circuit de commutation commande la grille d'un transistor de transfert de type P M8, dont la source est reliée au haut niveau de tension VPP et le drain à un circuit de charge L auquel il faut appliquer la haute tension. Ce qu'il faut dans ce cas, c'est ou bien bloquer le transistor de puissance M8 et donc imposer sur sa grille le plein niveau de tension VPP: ou bien rendre fortement passant le transistor de puissance M8 et imposer sur sa grille un niveau suffisamment proche de 0 volt pour qu'il laisse passer beaucoup de courant. Mais il n'est pas nécessaire d'appliquer 0 volt. Appliquer une tension de l'ordre de 1 volt suffit. Par analogie, si le transistor de transfert est de type N, son drain étant connecté à la haute tension VPP et sa source au circuit de charge L, il faut appliquer 0 volt sur sa grille pour le bloquer, mais appliquer une tension proche de VPP suffit à le rendre fortement passant. On note que le transistor de transfert de type P permet de transférer VPP sur le circuit de charge, sans pertes, tandis que le transistor de type N ne permet de transférer que VPP diminué de la tension de seuil du transistor de transfert.

Le circuit décrit et représenté à la figure 3 convient donc bien aux commandes de charges capacitives pour commuter un haut niveau de tension. Sa réalisation est très simple et peu coûteuse. Notamment les diodes sont formées par des transistors de type N ou P. Ce circuit permet de protéger efficacement les transistors de type N et P du circuit de commutation.

De plus, il n'est pas dépendant de la tension d'alimentation nominale Vcc du circuit, contrairement à l'art antérieur. Le circuit de commutation est ainsi libéré des problèmes liés aux niveaux de tension VPP et Vcc l'un par rapport à l'autre. Le circuit de commutation ne dépend plus que du niveau de tension VPP. On obtient donc la protection requise des transistors du circuit dans tous les cas de figures que VPP soit au bon niveau ou non, et quel que soit l'état de Vcc.

Le circuit de commutation que l'on vient de décrire a une impédance de sortie très forte. En effet, les transistors M2 et M3 doivent être assez résistifs pour que les transistors de type N puissent amener le potentiel de leurs drains à un niveau proche de 0 volt. Ce circuit de commutation ne peut donc commander que des charges capacitives.

Or, dans bien des applications on a aussi besoin de commander de hauts niveaux de tension sur des charges résistives, par exemple dans un circuit de génération de tension analogique. Les niveaux à commuter doivent alors être très précis. On doit commuter réellement 0 volt et VPP. Commuter VPP et vi ou commuter VPP-vi et 0 volt n'est pas acceptable. En effet, ces circuits utilisent comme paramètre le courant qui passe dans la résistance. Ce courant dépend très fortement des niveaux de tension qui sont appliqués à la résistance.

Dans ces conditions, le circuit de commutation tel que vu dans la figure 3 ne convient pas. Car si l'on place une résistance en série entre le niveau de haute tension VPP et une sortie du circuit de commutation prise sur le drain d'un transistor de commutation, par exemple M1, lorsque le signal de commutation C vaut 5 volts, le transistor M1 est bloqué ; il n'y a pas de courant à passer dans la résistance. La chute de tension étant nulle sur la résistance, cette dernière ramène donc la haute tension VPP sur le drain du transistor M1 : c'est la charge résistive qui vient ici stresser le transistor de commutation. De manière analogue, si on place une résistance en série entre la masse et une sortie du circuit de commutation prise sur le drain d'un transistor de charge, par exemple M3, lorsque le signal de commutation vaut 0 volt, le transistor M3 est bloqué; il n'y a pas de courant à passer dans la résistance. La chute de tension étant nulle sur la résistance, cette dernière ramène 0 volt sur le drain du transistor M3 : c'est la charge résistive qui vient stresser le transistor de charge.

De plus, le circuit de commutation de la figure 3, ne peut pas commuter sur une même sortie OUT le 0 volt et le VPP : l'un des niveaux est affecté par une tension de seuil de diode. Et cette tension de seuil de diode est une grandeur qui varie avec les procédés et avec l'effet de substrat et sur laquelle on peut donc avoir une imprécision.

Dans l'invention, on propose un mode de réalisation d'un circuit de commutation pour pouvoir commuter 0 volt ou VPP sur une charge résistive. Ce mode de réalisation est représenté sur la figure 4.

Selon l'invention, on place un transistor d'isolation en série, entre la résistance et la sortie OUT du circuit de commutation prise sur une branche. La grille de ce transistor est commandée par une sortie prise sur l'autre branche. Dans l'exemple représenté sur la figure 4, en partant du circuit de la figure 3, on place un transistor d'isolation de type N M9 entre une résistance R et le drain du transistor de commutation M1. L'autre borne de la résistance R est connectée au niveau de haute tension VPP. Le transistor d'isolation M9 a sa grille connectée au point de connexion A entre la diode D0 et le transistor de charge M2.

Dans l'exemple choisi et représenté sur la figure 4, lorsque le signal de commutation C est à 5 volts, le transistor de commutation M0 est passant et le transistor de commutation M1 est bloqué. On a vu dans ce cas que le potentiel du drain du transistor M1 est égal à VPP-v1. Le potentiel de la grille du transistor d'isolation M9 qui est commandé par le point de connexion A entre le transistor de charge M2 et la diode D0 est égal à la tension de seuil v0 de la diode D0.

Le transistor d'isolation M9 de type N qui a donc VPP-v1 sur sa source et v0 sur sa grille n'est pas conducteur. Il ne passe aucun courant dans la résistance R. Le potentiel du drain du transistor d'isolation M9 est porté à VPP.

Lorsque le signal de commutation C est à 0 volt, le transistor M1 est passant et le transistor M0 est bloqué. Le transistor M0 étant bloqué, le potentiel au point de connexion A entre la diode D0 et le transistor M2 est à VPP. On applique donc VPP sur la grille du transistor d'isolation M9. Le transistor M1 est passant : le potentiel de son drain est à 0 volt. On a donc 0 volt sur la source du transistor d'isolation M9 lequel est alors fortement passant et amène le potentiel de son drain à 0 volt. On obtient pleinement la chute de tension VPP aux bornes de la résistance R.

Lorsque le signal de commutation C est à 0 volt, le transistor d'isolation M9 n'est pas protégé du stress : Il a VPP sur sa grille, 0 volt sur sa source et 0 volt sur son drain.

Dans un perfectionnement représenté en figure 5 du mode de réalisation représenté en figure 4, on propose de placer une diode D2 polarisée en direct entre la diode D0 et le transistor de charge M2 de la première branche, et de prendre comme sortie de commande de la grille du transistor d'isolation M9, le point de connexion A entre les deux diodes D0 et D2. Lorsque le transistor de commutation M0 est passant, le potentiel au point de connexion A est égal à la tension de seuil v0 de la diode D0. Et lorsque le transistor M0 est bloqué, comme on a une chute de tension aux bornes de la diode D2 égale à sa tension de seuil v2, le potentiel du point de connexion A n'est plus VPP, mais VPP-v2. La tension de la grille du transistor d'isolation M9 est alors soit v0, soit VPP-v2 et on a alors un transistor d'isolation protégé du stress quels que soient les niveaux de tension sur sa source et son drain.

On déduit aisément la solution duale pour une résistance placée entre la masse et le drain d'un transistor de charge P par exemple M3. Le transistor d'isolation selon l'invention sera alors de type P et placé en série entre la résistance et le drain du transistor de charge M3 avec sa grille commandée avantageusement par le point de connexion entre la diode D0 et la diode D2, de manière à diminuer de plusieurs ordres de grandeur le stress auquel il est soumis.

Le mode de réalisation décrit et représenté sur la figure 4, ou sa solution duale non représentée permettent donc de commuter pleinement 0 volt ou pleinement VPP sur une charge résistive R, tout en protégeant du stress les différents transistors de commutation du circuit de commutation et dans un perfectionnement représenté sur la figure 5, en protégeant le transistor d'isolation associé à la charge résistive.

De préférence et avantageusement, le circuit de commutation est réalisé en technologie CMOS. Dans ce cas, on prévoit pour les deux diodes D1 et D2 de la première branche que l'une est réalisée à partir d'un transistor de type N, et l'autre à partir d'un transistor de type P, pour avoir une structure symétrique facile à réaliser en technologie CMOS. Dans l'exemple représenté sur la figure 5, on ajoute avantageusement une diode D3 représentée en pointillé polarisée en direct entre la diode D1 et le transistor M3 de la deuxième branche du circuit de commutation, afin d'obtenir une structure parfaitement symétrique. On a alors une chute de tension supplémentaire dans la deuxième branche égale à la tension de seuil v3 de la diode D3. Le drain du transistor M1 sera alors à un potentiel égal soit à 0 volt soit à VPP-v1-v3.

Dans l'exemple de la figure 5, les diodes D2 et D3 sont réalisées avec un transistor de type P dont la grille est reliée au drain. Il est à noter que dans le cas où les diodes sont réalisées par les transistors N ou P, la tension de seuil de la diode est égale à une tension de seuil du transistor N pour un transistor N et à une tension de seuil d'un transistor P pour un transistor P.

Dans la représentation choisie de la figure 5, la grille du transistor P M2 est commandée par le point de connexion placé entre la diode D2, et le transistor de charge M2 et la grille du transistor M2 est commandée par le point de connexion placé entre la diode D3 et le transistor de charge M2. Quand le signal de commutation C est à 5 volts, le transistor de charge M2 a sur sa grille un potentiel VPP et le transistor de charge M3 a sur sa grille un potentiel v0. Quand le signal de commutation C est à 0 volt, le transistor M2 a, sur sa grille, un potentiel v1 et le transistor M3 a, sur sa grille, un potentiel VPP.

Il est tout à fait possible, dans une autre réalisation, non représentée, de commander la grille d'un transistor de charge d'une branche, par le point de connexion entre les deux diodes de l'autre branche.

Le circuit de commutation selon l'invention, permet donc de commuter un haut niveau de tension VPP sur une charge résistive, sans provoquer de stress des transistors du circuit de commutation et sans dépendre du niveau pris par VPP ou par Vcc. Il en ressort que le circuit programmable dans lequel il est intégré est beaucoup mieux protégé et beaucoup plus fiable puisque le circuit de commutation ne risque pas d'être endommagé par une mauvaise alimentation du circuit ou par un défaut des sources d'alimentation.

## Revendications

1. Circuit de commutation d'une haute tension VPP comprenant deux branches, chaque branche comportant un transistor MOS de type P (M2, M3) et un transistor MOS de type N (M0, M1) en série entre la haute tension VPP et la masse, chaque transistor P (M2) ayant sa grille connectée au point de connexion (B) entre le transistor P et le transistor N de l'autre branche, le transistor N (M0) d'une branche recevant, sur sa grille, un signal de commutation (C), le transistor N (M1) de l'autre branche recevant sur sa grille le signal de commutation inversé (/C), caractérisé en ce qu'il comporte en outre, dans chaque branche, au moins une diode de protection polarisée en direct et connectée entre le transistor P et le transistor N et en ce qu'une résistance (R) est connectée en série avec un transistor d'isolation (M9) entre la haute tension VPP et une sortie (OUT) du circuit prise au drain du transistor N (M1) d'une première branche, la grille du transistor d'isolation (M9) étant reliée à une sortie du circuit prise sur la deuxième branche.

2. Circuit de commutation d'une haute tension VPP comprenant deux branches, chaque branche comportant un transistor MOS de type P (M2, M3) et un transistor MOS de type N (M0, M1) en série entre la haute tension VPP et la masse, chaque transistor P (M2) ayant sa grille connectée au point de connexion (B) entre le transistor P et le transistor N de l'autre branche, le transistor N (M0) d'une branche recevant, sur sa grille, un signal de commutation (C), le transistor N (M1) de l'autre branche recevant sur sa grille le signal de commutation inversé (/C), caractérisé en ce qu'il comporte en outre, dans chaque branche, au moins une diode de protection polarisée en direct et connectée entre le transistor P et le transistor N et en ce qu'une résistance (R) est connectée en série avec un transistor d'isolation (M9) entre la masse et une sortie (OUT) du circuit prise au drain du transistor P (M1) d'une première branche, la grille du transistor d'isolation (M9) étant reliée à une sortie du circuit prise sur la deuxième branche.

3. Circuit de commutation selon la revendication 1, caractérisé en ce qu'une première diode (D2) polarisée en direct est placée en série entre le drain du transistor P (M2) et la diode de protection (D0) dans la deuxième branche, et que la sortie sur cette branche pour commander la grille du transistor d'isolation (M9) est prise au point de connexion entre la première diode (D2) et la diode de protection (D0).

4. Circuit de commutation selon la revendication 3, caractérisé en ce qu'une deuxième diode polarisée en direct est placée dans la première branche de manière symétrique à la deuxième diode de la deuxième branche.

5. Circuit de commutation selon l'une des revendications précédentes, caractérisé en ce qu'il est réalisé en technologie CMOS, les deux diodes d'une branche étant deux transistors, l'un de type P, l'autre de type N.

## Patentansprüche

1. Schaltkreis zum Schalten einer hohen Spannung VPP, der zwei Zweige aufweist, wobei jeder Zweig einen MOS-Transistor vom P-Typ (M2, M3) und einen MOS-Transistor vom N-Typ (M0, M1) in Reihe zwischen der hohen Spannung VPP und Masse umfaßt, wobei jeder P-Transistor (M2) über sein Gate mit dem Verbindungspunkt (B) zwischen dem P-Transistor und dem N-Transistor des anderen Zweiges verbunden ist, der N-Transistor (MO) eines Zweiges über sein Gate ein Schaltsignal (C) empfängt, der N-Transistor (M1) des anderen Zweiges über sein Gate das inverse Schaltsignal (/C) empfängt, dadurch gekennzeichnet, daß er außerdem in jedem Zweig wenigstens eine in Vorwärtsrichtung betriebene und zwischen P-Transistor und N-Transistor geschaltete Schutzdiode umfaßt und daß ein Widerstand (R) mit einem Isolationstransistor (M9) zwischen die hohe Spannung VPP und einen Ausgang (OUT) des Schaltkreises, der am Drain des N-Transistors (M1) eines ersten Zweiges abgegriffen wird, in Reihe geschaltet ist, wobei das Gate des Isolationstransistors (M9) mit einem Ausgang des Schaltkreises verbunden ist, der am zweiten Zweig abgegriffen wird.

2. Schaltkreis zum Schalten einer hohen Spannung VPP, der zwei Zweige aufweist, wobei jeder Zweig einen MOS-Transistor vom P-Typ (M2, M3) und einen MOS-Transistor vom N-Typ (M0, M1) in Reihe zwischen der hohen Spannung VPP und Masse umfaßt, wobei jeder P-Transistor (M2) über sein Gate mit dem Verbindungspunkt (B) zwischen dem P-Transistor und dem N-Transistor des anderen Zweiges verbunden ist, der N-Transistor (M0) eines Zweiges über sein Gate ein Schaltsignal (C) empfängt, der N-Transistor (M1) des anderen Zweiges über sein Gate das inverse Schaltsignal (/C) empfängt, dadurch gekennzeichnet, daß er außerdem in jedem Zweig wenigstens eine in Vorwärtsrichtung betriebene und zwischen P-Transistor und N-Transistor geschaltete Schutzdiode umfaßt und daß ein Widerstand (R) mit einem Isolationstransistor (M9) zwischen Masse und einen Ausgang (OUT) des Schaltkreises, der am Drain des P-Transistors (M1) eines ersten Zweiges abgegriffen wird, in Reihe geschaltet ist, wobei das Gate des Isolationstransistors (M9) mit einem Ausgang des Schaltkreises verbunden ist, der an dem zweiten Zweig abgegriffen wird.

3. Schaltkreis zum Schalten nach Anspruch 1, dadurch gekennzeichnet, daß eine erste in Vorwärtsrichtung betriebene Diode (D2) in Reihe zwischen Drain des P-Transistors (M2) und die Schutzdiode (DO) in dem zweiten Zweig angeordnet ist, und daß der Ausgang auf dem Zweig zum Steuern des Gates des Isolationstransistors (M9) am Verbindungspunkt zwischen der ersten Diode (D2) und der Schutzdiode (D0) abgegriffen wird.

4. Schaltkreis zum Schalten nach Anspruch 3, dadurch gekennzeichnet, daß eine zweite in Vorwärtsrichtung betriebene Diode im ersten Zweig symmetrisch zu der zweiten Diode des zweiten Zweiges angeordnet ist.

5. Schaltkreis zum Schalten nach einem der vorangehenden Ansprüche, dadurch gekennzeichnet, daß er in CMOS-Technologie hergestellt ist, wobei die beiden Dioden eines Zweiges zwei Transistoren sind, der eine vom P-Typ, der andere vom N-Typ.

## Claims

1. A switching circuit for a high voltage VPP comprising two legs, each leg comprising a P type MOS transistor (M2, M3) and an N type MOS transistor (MO, Ml) in series between the high voltage VPP and the earth, each P transistor (M2) having its gate connected to the connection point (B) between the P transistor and the N transistor of the other leg, the N transistor (MO) of one leg receiving, on its gate, a switching signal (C), the N transistor (M1) of the other leg receiving on its gate the inverted switching signal (/C),
**characterised in that** it also comprises, in each leg, at least one protection diode directly biased and connected between the P transistor and the N transistor,
**and in that** a resistor (R) is connected in series with an insulating transistor (M9) between the high voltage VPP and an output (OUT) of the circuit taken at the drain of the N transistor (M1) of a first line, the gate of the insulating transistor (M9) being connected to an output of the circuit taken on the second leg.

2. A switching circuit for a high voltage VPP comprising two legs, each leg comprising a P type MOS transistor (M2, M3) and an N type MOS transistor (M0, M1) (M0, M1) in series between the high voltage VPP and the earth, each P transistor (M2) having its gate connected to the connection point (B) between the P transistor and the N transistor of the other leg, the N transistor (MO) of one leg receiving, on its gate, a switching signal (C), the transistor N (M1) of the other leg receiving on its gate the inverted switching signal (/C),
**characterised in that** it also comprises, in each leg, at least one protection diode directly biased and connected between the P transistor and the N transistor,
**and in that** a resistor (R) is connected in series with an insulating transistor (M9) between the mass and an output (OUT) of the circuit taken at the drain of the P transistor (M1) of a first leg, the gate of the insulating transistor (M9) being connected to an output of the circuit taken on the second leg.

3. A switching circuit according to CLaims 1,
**characterised in that** a first directly biased diode (D2)is placed in series between the drain of the P transistor (M2) and the protection diode (DO) in the second leg,
**and in that** the output on this leg to control the gate of the insulating transistor (M9) is taken at the connection point between the first diode (D2) and the protection diode (DO).

4. A switching circuit according to Claim 3,
**characterised in that** a second directly biased diode is placed in the first leg symmetrically to the second diode of the second leg.

5. A switching circuit according to one of the preceding Claims,
**characterised in that** it is constructed by CMOS technology, the two diodes of one leg being two transistors, one of the P type, the other of the N type.
